# EUROPÄISCHE PATENTANMELDUNG

(11) **EP 0 822 662 A2**
(43) Veröffentlichungstag der Anmeldung: **04.02.1998**
(21) Anmeldenummer: 97112556.2
(22) Anmeldetag: 22.07.1997
(51) Int. Cl.: H03K 19/003, H03K 19/0175

(54) **Schnittstellenschaltung**

(30) Priorität: 01.08.1996 DE 19631117
(71) Anmelder: SIEMENS AKTIENGESELLSCHAFT, 80333 München (DE)
(72) Erfinder: Weber, Stephan, Dr., 81739 München (DE); Thomas, Volker, Dr., 81245 München (DE)

(57) **Zusammenfassung**

Schnittstellenschaltung zur Übertragung binärer Signale mit einer Signalsendeeinrichtung (X), mit einer Signalempfangseinrichtung ( R) sowie mit einer dazwischengeschalteten Übertragungseinrichtung (T), wobei die Signalseindeeinrichtung Mittel (7, 7') zur Begrenzung der Steilheit von ansteigender und abfallender Flanke der binären Signale auf bestimmte einander gleiche Steigungswerte aufweist.

## Beschreibung

Die Erfindung betrifft eine Schnittstellenschaltung zur Übertragung binärer Signale mit einer Signalsendeeinrichtung, mit einer Signalempfangseinrichtung sowie mit einer dazwischen geschalteten Übertragungseinrichtung.

Derartige Schnittstellenschaltungen sind in vielfältigen Ausgestaltungen beispielsweise aus U. Tietze, Ch. Schenk, Electronic Circuits-Design and Applications, Springer-Verlag Berlin, Heidelberg 1991, Seiten 608 bis 629 bekannt. Bei der Übertragung binärer Signale tritt in Verbindung mit empfindlichen Analogschaltungen sehr häufig das Problem der Störung analoger Schaltungsteile auf. Die Störungen kann man zwar durch Verringern der Signalamplitude reduzieren, doch wird damit häufig die Schnittstelle selbst störungsempfindlicher. Besonders kritisch ist die Verringerung der Signalamplitude dann, wenn der Umschaltzeitpunkt -beispielsweise von High nach Low- genau erkannt werden soll. Hierfür werden in der Regel möglichst steile Impulse mit großer Amplitude eingesetzt, die jedoch ein besonders breites Signalspektrum und daher eine hohe Störwirkung aufweisen. Bei steilen Impulsen besteht darüber hinaus die Gefahr, daß durch die Übertragungseinrichtung die steigende und die fallende Flanke der binären Signale in unterschiedlicher Weise abgeflacht werden, so daß sich aufgrund des sich dadurch verändernden Tastverhältnisses weitere Übertragungsfehler ergeben.

Aufgabe der Erfindung ist es, eine Schnittstellenschaltung anzugeben, die sowohl eine hohe Übertragungsgenauigkeit als auch eine geringe eigene Störanfälligkeit sowie eine geringe Störwirkung auf andere Schaltungsteile aufweist.

Die Aufgabe wird durch eine Schnittstellenschaltung gemäß Patentanspruch 1 gelöst. Ausgestaltungen und Weiterbildungen des Erfindungsgedankens sind Gegenstand von Unteransprüchen.

Aktive und passive Störsicherheit bei hoher Übertragungsgenauigkeit wird bei der erfindungsgemäßen Schnittstellenschaltung insbesondere dadurch erzielt, daß die Signalsendeeinrichtung Mittel zur Begrenzung der Steilheit von ansteigender und abfallender Flanke der binären Signale auf bestimmte, einander gleiche Steigungswerte aufweist. Durch Abflachen der Signalflanken wird das Störspektrum geschmälert, so daß die aktive Störsicherheit, d.h. die Störwirkung auf andere Schaltungsteile verringert wird. Dabei bleibt jedoch die Signalamplitude erhalten, so da die passive Störsicherheit, d.h. die Störeinwirkung anderer Schaltungsteile auf die Schnittstelle dadurch nicht verschlechtert wird. Durch die Verringerung der Bandbreite werden darüber hinaus bandbegrenzende Einwirkungen der Übertragungseinrichtung auf die Schnittstelle weitgehend ausgeschaltet.

Bei einer Weiterbildung der Erfindung sendet die Signalsendeeinrichtung die binären Signale als entsprechend eingeprägte Ströme über die Übertragungseinrichtung an die Empfangseinrichtung. Die Signalsendeeinrichtung ist dabei als möglichst hochohmige Quelle ausgelegt, während die Signalempfangseinrichtung einen möglichst niederohmigen Stromeingang aufweist. Daraus ergibt sich, daß der Spannungshub an der Übertragungseinrichtung sehr gering ist, wodurch insbesondere eine kapazitive Einkopplung von Störungen auf andere Schaltungsteile stark verringert wird.

Eine weitere Verbesserung wird durch eine gegenphasige, symmetrische Signalführung ermöglicht, da sich dann die Störsignale an der Störsenke zum großen Teil aufheben, während das Differenzsignal sogar der doppelten Einzelamplitude entspricht. Dementsprechend sind Signalsendeeinrichtung, Übertragungseinrichtung und Signalempfangseinrichtung zur Übertragung symmetrischer, binärer Signale ausgelegt.

Zur Gewinnung des Differenzsignals ist dabei eine Subtraktionseinrichtung in der Signalempfangseinrichtung vorgesehen.

Zur Begrenzung der Flankensteilheit werden insbesondere Integrationsmittel in den Signalzweig der Signalsendeeinrichtung gesetzt, die mit dem zu übertragenden binären Signalen angesteuert werden und die für einen gleichmäßigen, linearen Anstieg bzw. Abfall der Flanken bei Ansteuerung mit Rechtecksignalen garantiert.

Bevorzugt wird als Integrationsmittel mindestens eine Millerkapazität in Verbindung mit einem im Signalzweig liegenden Transistor verwendet. Da der Transistor meist ohnehin vorhanden ist, wird durch die zwischen Basis und Kollektor des Transistors geschaltete Millerkapazität mit geringstem zusätzlichen Aufwand ein Integrator realisiert.

Schließlich wird der Signalempfangseinrichtung bevorzugt ein Komparator nachgeschaltet, um aus den Signalen mit flacher Flanke wieder binäre Signale mit steilen Flanken zu generieren. Die Komparatorschwelle wird dabei bevorzugt in die Mitte zwischen maximaler und minimaler Amplitude des übertragenen Signals gelegt.

Die Erfindung wird nachfolgend anhand des in den Figuren der Zeichnung dargestellten Ausführungsbeispiels näher erläutert. Es zeigt:
- Figur 1: ein Ausführungsbeispiel einer erfindungsgemäßen Schnittstellenschaltung in einem Schaltbild und
- Figur 2: den Signalverlauf in der Übertragungseinrichtung bei einer Schnittstellenschaltung gemäß Figur 1.

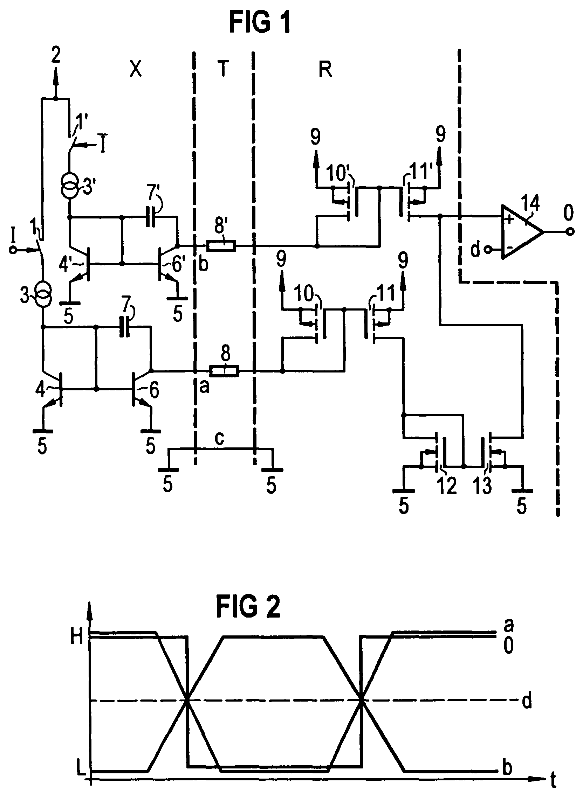

Bei dem als Ausführungsbeispiel gezeigten Schnittstellenschaltung gemäß Figur 1 ist eine Signalsendeeinrichtung X, eine Signalempfangseinrichtung R sowie eine dazwischengeschaltete Übertragungseinrichtung T vorgesehen. Signalsendeeinrichtung X, Übertragungseinrichtung T und Signalempfangseinrichtung R sind zumindest an den Verbindungsstellen zueinander symmetrisch ausgelegt.

Die Signalsendeeinrichtung X umfaßt neben weiteren nicht dargestellten Schaltungsteilen zwei über gegenphasig durch Eingangssignale I bzw. I angesteuerte Schaltmittel 1 bzw. 1'. Mit den Schaltmitteln 1 und 1' wird ein positives Versorgungspotential 2 über jeweils eine Stromquelle 3 bzw. 3' auf den Eingangskreis jeweils eines Stromspiegels aufgeschaltet. Die Stromspiegel bestehen aus jeweils einem npn-Transistor 4 bzw. 4', dessen Emitter an einem Bezugspotential 5 angeschlossen sind und dessen Basis und Kollektor zum einen mit der jeweils zugehörigen Stromquelle 3 bzw. 3' sowie jeweils mit der Basis eines weiteren npn-Transistors 6 bzw. 6' gekoppelt ist. Die Emitter der Transistoren 6 und 6' sind an das Bezugspotential 5 angeschlossen und ihre symmetrische Ausgänge der Signalsendeeinrichtung bildenden Kollektoren sind über jeweils einen Kondensator 7 bzw. 7' mit ihren jeweiligen Basen verbunden. Die Kondensatoren 7 und 7' bilden in Verbindung mit den Transistoren 6 und 6' Millerkapazitäten, welche Integrationsmittel zum Abflachen von ansteigender und abfallender Flanke von zu übertragenden Binärsignalen darstellen. Die Steigung von ansteigender und abfallender Flanke sind aufgrund der Integration gleich. Die zu übertragenden Binärsignale werden in zwei komplementäre Signale aufgespalten und dienen als Signale I und I' zur Ansteuerung der Schaltmittel 1 und 1'.

Die Übertragungseinrichtung T besteht im einfachsten Fall aus einer mehradrigen Leitung mit beispielsweise drei Adern a, b, c, wobei die Ader c das Bezugspotential 5 überträgt. Die Adern a und b weisen dabei einen bestimmten Leitungswiderstand auf oder aber es ist wie beim Ausführungsbeispiel gezeigt, jeweils ein Widerstand 8 bzw. 8' in die jeweilige Leitung a bzw. b geschaltet, der den Durchgangswiderstand der Übertragungseinrichtung T im wesentlichen bestimmt und beispielsweise auch zur Stromeinstellung verwendet werden kann.

Die Signalempfangseinrichtung R umfaßt eingangsseitig zwei auf ein positives Versorgungspotential 9 bezogene Stromspiegel. Diese bestehen eingangsseitig aus jeweils MOS-Feldeffekttransistoren 10 bzw 10 vom p-Kanal-Typ, dessen Sourceanschluß mit dem positiven Versorgungspotential 9 verbunden ist. Gate- und Drainanschluß der Transistoren 10 und 10' sind zum einen miteinander und zum anderen mit dem Gateanschluß eines MOS-Feldeffekttransistors 11 bzw. 11, direkt und über den Widerstand 8 bzw. 8' mit dem Kollektor des Transistors 6 bzw. 6' gekoppelt. Die Drainanschlüsse der Transistoren 11 und 11' sind dabei ebenfalls an das positive Versorgungspotential 9 angeschlossen. Der Drainanschluß des Transistors 11 ist mit Drain- und Gateanschluß eines MOS-Feldeffekttransistors 12 vom n-Kanal-Typ sowie mit dem Gateanschluß eines MOS-Feldeffekttransistors 13 von n-Kanal-Typ gekoppelt. Die Sourceanschlüsse der Transistoren 12 und 13 sind auf Bezugspotential 5 gelegt. Die Drainanschlüsse der Transistoren 13 und 11' sind zusammengeführt und mit dem nichtinvertierenden Eingang eines Komparators 14 verbunden. Die Transistoren 10, 10' bis 13 bilden dabei eine Subtrahiereinrichtung, die aus den symmetrischen, mittels der Übertragungseinrichtung T übertragenen Signalen in unsymmetrische Signale gewinnt. Diese unsymmetrischen Signale weisen jedoch abgeflachte Flanken auf, die mit dem nachfolgenden Komparator 14 in steile Flanken umgewandelt werden sollen. Dazu ist an den invertierenden Eingang des Komparators 14 ein den Schwellenwert charakterisierender Strom d angelegt. Durch Vergleich mit dem Schwellenwert d erscheint ein Ausgangssignal O am Ausgang des Komparators 14, das im wesentlichen dem den Eingangssignalen I und I zugrundeliegenden Signal entspricht.

Der Verlauf verschiedener Signale über der Zeit t für eine Schnittstellenschaltung gemaß Figur 1 ist ein Figur 2 dargestellt. Das Signal auf der Leitung a ist dabei zunächst auf einem hohen Pegel H und fällt nach einer bestimmten Zeit allmählich auf einen niedrigeren Pegel L ab. In entsprechender Weise ist das Signal auf der Leitung b zunächst auf dem niedrigeren Pegel L und nimmt nach der bestimmten Zeit in gleicher Weise allmählich zu, wie das Signal auf der Leitung a abnimmt. Danach ist das Signal auf der Leitung a auf niedrigem Pegel L und das Signal auf der Leitung B. Danach fällt das Signal auf der Leitung b allmählich ab, während das Signal auf der Leitung a dementsprechend steigt. Im Anschluß daran ist das Signal auf der Leitung a wieder auf dem hohen Pegel A und das Signal auf der Leitung b auf dem niedrigeren Pegel L. Wird nun das als Schwelle vorgesehene Signal d des Komparators 15 exakt in die Mitte zwischen hohem Pegel H und niedrigem Pegel L gelegt und demgegenüber das Differenzsignal der beiden auf den Leitungen a und b übertragenen Signale bewertet, so ergibt sich für das Ausgangssignal O ein Verlauf, bei dem das Signal O zunächst auf dem hohen Pegel H sich befindet. Beim Schnittpunkt der fallenden Flanke des Signals auf der Leitung A und der steigenden Flanke des Signals auf der Leitung b, d.h. zu diesem Zeitpunkt, fällt auch das Signal O vom hohen Pegel H auf den niedrigen Pegel L. In gleicher Weise kippt das Signal beim darauffolgenden Schnittpunkt der fallenden Flanke des Signals auf der Leitung b und der steigenden Flanke des Signals auf der Leitung a vom niedrigen Pegel L auf den hohen Pegel A. Somit ergibt sich insgesamt ein unsymmetrisches Binärsignal mit steilen Flanken und exaktem Tastverhältnis.

## Patentansprüche

1. Schnittstellenschaltung zur Übertragung binärer Signale mit einer Signalsendeeinrichtung (X), mit einer Signalempfangseinrichtung ( R) sowie mit einer dazwischengeschalteten Übertragungseinrichtung (T),
**dadurch gekennzeichnet,** daß die Signalseindeeinrichtung Mittel (7, 7') zur Begrenzung der Steilheit von ansteigender und abfallender Flanke der binären Signale auf bestimmte einander gleiche Steigungswerte aufweist.

2. Schnittstellenschaltung nach Anspruch 1,
**dadurch gekennzeichnet,** daß die Signalsendeeinrichtung (X) die binären Signale als entsprechend eingeprägte Ströme über die Übertragungseinrichtung (T) an die Empfangseinrichtung sendet.

3. Schnittstellenschaltung nach Anspruch 1 oder 2,
**dadurch gekennzeichnet,** daß Signalsendeeinrichtung (X), Übertragungseinrichtung (T) und Signalempfangseinrichtung (R) zur Übertragung symmetrischer, binärer Signale ausgelegt sind.

4. Schaltungsanordnung nach Anspruch 3,
**dadurch gekennzeichnet,** daß die Signalempfangseinrichtung (R ) eine Subtraktionseinrichtung (10, 10' bis 13) zur Umwandlung von über die Übertragungseinrichtung (T) übertragener symmetrischer Signale in unsymmetrische Signale (O) enthält.

5. Schnittstellenschaltung nach einem der Ansprüche 1 bis 4,
**dadurch gekennzeichnet,** daß zur Begrenzung der Flankensteilheit Integrationsmittel (7, 7') im Signalzweig der Signalsendeeinrichtung (X) vorgesehen sind, die mit den übertragenden binären Signalen angesteuert werden.

6. Schnittstellenschaltung nach Anspruch 5,
**dadurch gekennzeichnet,** daß als Integrationsmittel mindestens eine Millerkapazität (7, 7') in Verbindung mit einem im Signalzweig liegenden Transistor (6, 6') vorgesehen ist.

7. Schnittstellenschaltung nach einem der Ansprüche 1 bis 6,
**dadurch gekennzeichnet,** daß der Signalempfangseinrichtung (R) Komparator (14) nachgeschaltet ist.
